# EUROPEAN PATENT SPECIFICATION

(11) **EP 4 407 744 B1**
(45) Date of publication and mention of the grant of the patent: **02.07.2025**
(21) Application number: 23215825.3
(22) Date of filing: 12.12.2023
(51) Int. Cl.: H01M 10/42, H01M 50/284, H01M 50/569, H05K 1/00

(54) **RECHARGEABLE BATTERY PACK**
WIEDERAUFLADBARES BATTERIEPACK
BLOC-BATTERIE RECHARGEABLE

(30) Priority: 02.01.2023 KR 20230000350
(43) Date of publication of application: 31.07.2024
(73) Proprietor: Samsung SDI Co., Ltd., Yongin-si, Gyeonggi-do 17084 (KR)
(72) Inventor: AHN, Jaepil, 17084 Yongin-si (KR); KWON, Young-Hwan, 17084 Yongin-si (KR); YUN, Chuljung, 17084 Yongin-si (KR); LEE, Byunghyun, 17084 Yongin-si (KR)
(74) Representative: Marks & Clerk LLP

(56) References cited:
- WO-A1-2022/126953
- CN-U- 217 719 886
- DE-A1- 102021 103 388

## Description

### BACKGROUND

### 1. Field

The present disclosure relates to a rechargeable battery pack for increasing electrical connection strength of a flexible printed circuit and a cell supervision circuit.

### 2. Description of the Related Art

A rechargeable battery repeats charging and discharging operations, unlike a primary cell. A small rechargeable battery is used for portable small electronic devices such as a mobile phone, a laptop computer, or a camcorder. A large capacity and high density rechargeable battery is used to store motor driving power or energy of hybrid vehicles and electric vehicles.

The rechargeable battery may be used as a single cell as in a small electronic device, or to achieve a large capacity for the purpose of driving a motor it may be used as a module in which a plurality of cells are electrically connected and a pack in which modules are electrically connected.

A flexible printed circuit (FPC) for sensing voltages or temperatures of the cells and transmitting them to a cell supervision circuit is installed in the rechargeable battery pack.

The flexible printed circuit and a cell supervision circuit (CSC) (or a cell monitor circuit (CMC)) are electrically connected to each other using a connector.

However, if the connector is attached/detached, a circuit connected to the connector may be frequently damaged so the durability of installation may be deteriorated.

### SUMMARY

The present disclosure provides a rechargeable battery pack for electrically connecting a flexible printed circuit and a cell supervision circuit by using an electrically conductive solder instead of a connector.

An embodiment of the present disclosure provides a rechargeable battery pack including: a cell assembly including at least one battery cell; a side frame accommodating the cell assembly; a flexible printed circuit (FPC) electrically connected to the cell assembly and configured to sense one or more properties of the battery cell; and a cell supervision circuit electrically connected to the flexible printed circuit and on one side of the side frame.

The flexible printed circuit is electrically connected to the cell supervision circuit by an electrically conductive solder.

The electrically conductive solder may include a solder or a conductive glue for electrically connecting the flexible circuit substrate and the cell supervision circuit.

The flexible printed circuit may include a number of circuit lines and a number of conductive pad portions at respective ends of the circuit lines electrically connected to the cell supervision circuit.

At least one conductive pad portion may protrude from the end of a circuit line with a size that is greater than a width of the circuit line and may be electrically connected to the cell supervision circuit by the electrically conductive solder.

The conductive pad portion may include a first expansion pad protruding from a first side of the circuit line in a width direction, and a second expansion pad protruding from a second side of the circuit line in the width direction.

The first expansion pad and the second expansion pad may protrude in a round shape from the end of the circuit line in directions that are opposite to each other.

A round groove may be between the first expansion pad and the second expansion pad.

A first step side connected to a lateral side of the flexible printed circuit may be at an end of the first expansion pad.

A second step side connected to a lateral side of the flexible printed circuit may be at an end of the second expansion pad.

A plated layer may be on surfaces of the first step side and the second step side.

A first spaced distance between an outer surface of the first expansion pad and an outer surface of the second expansion pad may be approximately 0.73 to approximately 0.74 times a spaced distance between adjacent circuit lines.

The first spaced distance may be approximately 1.22 to approximately 1.23 times a second spaced distance between a step of the first expansion pad and a step of the second expansion pad.

The electrically conductive solder may be a cream solder applied to the first step side, the second step side, and the round groove, may be bonded by laser heat, and may be electrically connected to the cell supervision circuit.

The electrically conductive solder may be a wire solder applied to the first step side, the second step side, and the round groove, may be bonded by laser heat, and may be electrically connected to the cell supervision circuit.

At least one circuit line may include a sub-pad portion spaced from the conductive pad portion and electrically connected to the cell supervision circuit by the electrically conductive solder.

The circuit line may include a slot hole in the sub-pad portion into which the electrically conductive solder is inserted.

A surface of the electrically conductive solder may be conformally coated.

At least some of the above and other features of the invention are set out in the claims.

According to the embodiment, the flexible printed circuit is electrically connected to the cell supervision circuit not by using an additional terminal but by using the electrically conductive solder such as a solder, thereby preventing disconnection of lines which might otherwise occur due to pressurized damages at the connected portion of the circuit, and thus allowing stable connection.

### BRIEF DESCRIPTION OF THE DRAWINGS

FIG. 1 shows a perspective view of a rechargeable battery pack according to a first embodiment of the present disclosure.
FIG. 2 shows a schematic perspective view of a flexible circuit substrate and a cell supervision circuit of FIG. 1 electrically connected by an electrically conductive solder.
FIG. 3 shows a schematic perspective view of a flexible circuit substrate and a cell supervision circuit of FIG. 2 electrically connected by an electrically conductive solder.
FIG. 4 shows a schematic perspective view of a state in which an electrically conductive solder of FIG. 2 is omitted.
FIG. 5 shows a state in which a conductive pad portion is formed while an electrically conductive solder of FIG. 4 is omitted.
FIG. 6 shows a schematic perspective view of a state in which a flexible circuit substrate is electrically connected to a cell supervision circuit according to a second embodiment of the present disclosure by an electrically conductive solder.
FIG. 7 shows a schematic perspective view of a state in which an electrically conductive solder of FIG. 6 is omitted.
FIG. 8 shows a schematic lateral view of a state in which an electrically conductive solder of FIG. 6 is omitted.

### DETAILED DESCRIPTION

The present disclosure will be described more fully hereinafter with reference to the accompanying drawings, in which embodiments of the disclosure are shown. As those skilled in the art would realize, the described embodiments may be modified in various different ways, all without departing from the scope of the present disclosure. The drawings and description are to be regarded as illustrative in nature and not restrictive. Like reference numerals designate like elements throughout the specification.

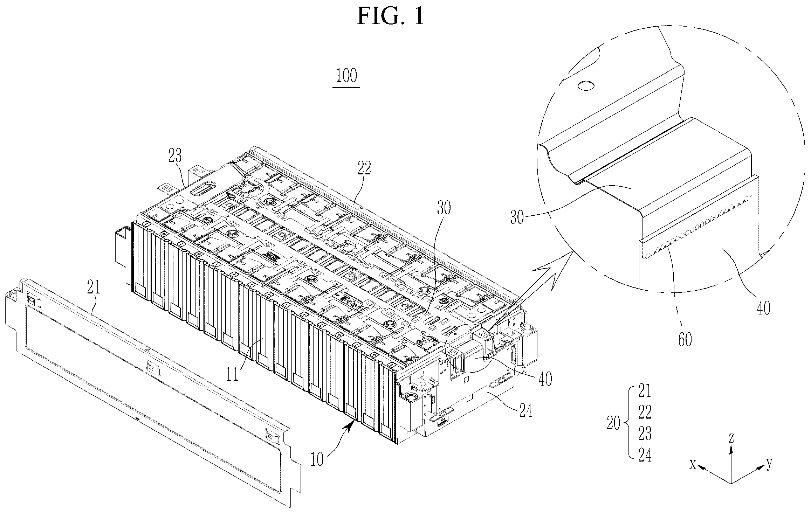

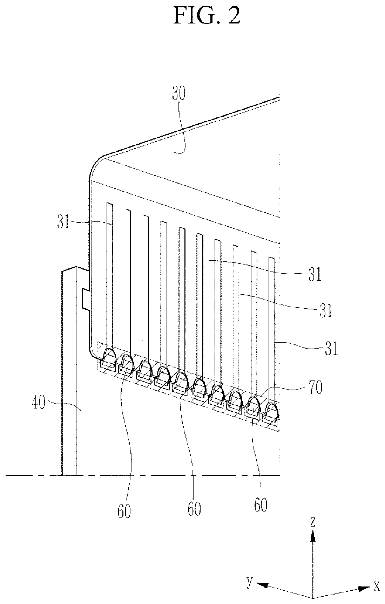

FIG. 1 shows a perspective view of a rechargeable battery pack according to a first embodiment of the present disclosure, and FIG. 2 shows a schematic perspective view of a flexible circuit substrate and a cell supervision circuit of FIG. 1 electrically connected by an electrically conductive solder.

As shown in FIG. 1 and FIG. 2, the rechargeable battery pack 100 according to a first embodiment of the present disclosure includes a cell assembly 10 including at least one battery cell 11, a side frame 20 for receiving (accommodating) the cell assembly 10, a flexible printed circuit (FPC) 30 electrically connected to the cell assembly 10 and configured to sense one or more properties of the battery cell 11, and a cell supervision circuit 40 connected to the flexible printed circuit 30 and installed on one side of the side frame 20. The flexible printed circuit 30 is electrically connected to the cell supervision circuit 40 by an electrically conductive solder 60.

A plurality of battery cells 11 may be configured with a conventional rechargeable battery for repeatedly performing a charging and discharging operation.

The side frame 20 may include a first side frame 21 for supporting first lateral sides of a plurality of battery cells 11, a second side frame 22 for supporting second lateral sides of the battery cells 11, a first end frame 23 of which respective ends are connected to first ends of the first side frame 21 and the second side frame 22, and a second end frame 24 of which respective ends are connected to second ends of the first side frame 21 and the second side frame 22.

The first side frame 21 may be installed to support first sides of the battery cells 11.

The second side frame 22 may be installed to support seconds sides of the battery cells 11.

The first end frame 23 may be installed to connect the first ends of the first side frame 21 and the second side frame 22. That is, the first end of the first end frame 23 may be connected to the first end of the first side frame 21 by a fastening member, and the second end of the first end frame 23 may be connected to the first end of the second side frame 22 by the fastening member.

The second end frame 24 may be installed to connect the second ends of the first side frame 21 and the second side frame 22. That is, the first end of the second end frame 24 may be connected to the second end of the first side frame 21 by the fastening member, and the second end of the second end frame 24 may be connected to the second end of the second side frame 22 by the fastening member.

The flexible printed circuit (FPC) 30, which is electrically connected to the cell assembly 10 and configured to sense one or more properties of the battery cell 11, may be installed on the side frame 20.

The flexible printed circuit 30 may be connected to the battery cell 11 and the cell supervision circuit 40, and may sense the voltage or the temperature of the battery cell 11 and may transmit the sensed results to the cell supervision circuit 40.

The flexible printed circuit 30 may include a plurality of circuit lines 31 coated with an insulation film.

The circuit lines 31 of the flexible printed circuit 30 may be electrically connected to the cell supervision circuit 40 on a side of the cell assembly 10.

The cell supervision circuit 40 may be referred to as a cell monitor circuit (CMC).

The cell supervision circuit 40 may receive a sensing signal of the battery cell 11 through the flexible printed circuit 30 and may confirm an abnormal operation state of the battery cell 11.

The cell supervision circuit 40 is installed on one position or location of the cell assembly 10, and in one or more embodiments, it may be installed on the second end frame 24 and it may be electrically connected to the flexible printed circuit 30. The present disclosure is not limited to the cell supervision circuit 40 being installed on the position of the second end frame 24, and in one or more embodiments the cell supervision circuit 40 may be installed on a different position such as on the first end frame 23.

The cell supervision circuit 40 may be electrically connected to the flexible printed circuit 30 by the electrically conductive solder 60.

In one or more embodiments, the cell supervision circuit 40 is electrically connected to the flexible printed circuit 30 by the electrically conductive solder 60 without using an additional terminal, thereby preventing disconnection of lines due to pressurized damages at the connected portion, and thus allowing a stable connection.

The electrically conductive solder 60 may function as a solder for electrically connecting the flexible printed circuit 30 and the cell supervision circuit 40. In one or more embodiments, the electrically conductive solder 60 may work as a conductive glue. The electrically conductive solder 60 working as a solder will now be described in detail. The electrically conductive solder and the solder will use an identical reference numeral.

A conductive pad portion 32 for adhering the solder 60 may be formed on the flexible printed circuit 30.

The conductive pad portion 32 is connected to the flexible printed circuit 30, the solder 60 is adhered to the conductive pad portion 32, and the conductive pad portion 32 may be electrically connected to the circuit lines 31 of the flexible printed circuit 30. In one or more embodiments, the rechargeable battery pack 100 may include one conductive pad portion 32 for each of the circuit lines 31.

The conductive pad portion 32 may have a bigger size (e.g., width) than the width of the circuit lines 31, may protrude from an end of the circuit lines 31, and may be electrically connected to the cell supervision circuit 40 by the solder 60.

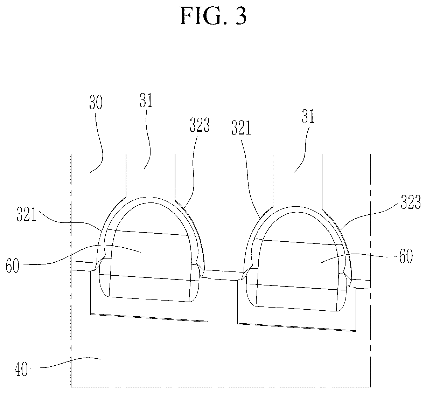

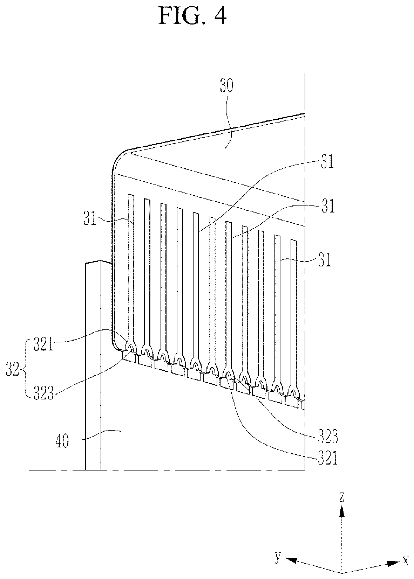

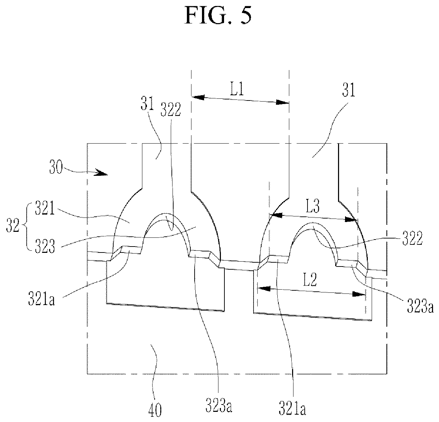

FIG. 3 shows a schematic perspective view of a flexible circuit substrate and a cell supervision circuit of FIG. 2 electrically connected by an electrically conductive solder, FIG. 4 shows a schematic perspective view of a state in which an electrically conductive solder of FIG. 2 is omitted, and FIG. 5 shows a state in which a conductive pad portion is formed while an electrically conductive solder of FIG. 4 is omitted.

Referring to FIG. 3 to FIG. 5, in further detail, the conductive pad portion 32 may include a first expansion pad 321 protruding toward a first side of the circuit line 31 in a width direction, and a second expansion pad 323 protruding toward a second side of the circuit line 31 in the width direction. In one or more embodiments, the directions of the first side and the second side are opposite to each other.

The first expansion pad 321 may be connected to protrude from an end of the circuit line 31 while protruding in a first side direction with respect to a center of the end of the circuit line 31.

The first expansion pad 321 is made of a same material as the circuit line 31 and protrudes in the first side direction while connected to the circuit line 31, and may protrude in a curved (e.g., round) shape from the end of the circuit line 31.

The second expansion pad 323 may protrude in an identical or similar shape to the first expansion pad 321 in a second side direction facing the first side direction from the end of the circuit line 31 (e.g., the first expansion pad 321 and the second expansion pad 323 may be symmetric).

The second expansion pad 323 is made of a same material as the circuit line 31 and protrudes in the second side direction while connected to the circuit line 31, and may protrude in a curved (e.g., round) shape from the end of the circuit line 31.

In one or more embodiments, the first expansion pad 321 and the second expansion pad 323 respectively protrude in a curved (e.g., round) shape in opposite directions, and may protrude while electrically connected to the end of the circuit line 31 and a round groove 322 may be formed between the first expansion pad 321 and the second expansion pad 323.

The formation of the round groove 322 between the first expansion pad 321 and the second expansion pad 323 is configured to allow firm electrical connection by providing a sufficient space in which the solder 60 is filled and by increasing a surface area of a portion on which the solder 60 is applied.

In one or more embodiments, step sides 321a and 323a may be formed at respective ends of the first expansion pad 321 and the second expansion pad 323. The formation of the step sides at the first expansion pad 321 and the second expansion pad 323 is to further increase the surface area in which the solder 60 is applied.

That is, an end of the first expansion pad 321 may be formed to be connected to an edge of the flexible printed circuit 30 along which the first step side 321a is formed.

An end of the second expansion pad 323 may be formed to be connected to the edge of the flexible printed circuit 30 along which the second step side 323a is formed.

Therefore, the solder 60 may be cured once the solder 60 has been sufficiently applied to the space formed by the first step side 321a and the second step side 323a and the space formed by the round groove 322.

Hence, the solder 60 may be applied with the maximum applied area between the flexible printed circuit 30 and the cell supervision circuit 40 and may then be cured so the cell supervision circuit 40 may be connected to the flexible printed circuit 30 while their electrical connection is maximized.

The solder 60 may be applied as a cream solder to the first step side 321a, the second step side 323a, and the round groove 322, it may be bonded by being cured by laser heat, and may then be electrically connected to the cell supervision circuit 40.

However, without being limited to the cream solder type, the solder 60 may be applied to the first step side 321a, the second step side 323a, and the round groove 322 in a wire solder type, and may be cured by laser heat.

A plated layer may be formed on the surfaces of the first step side 321a and the second step side 323a so if the solder 60 is applied and cured, the electrical connection operation may be performed.

In one or more embodiments, a first spaced distance between an outer surface of the first expansion pad 321 and an outer surface of the second expansion pad 323 may be within a distance range of approximately 0.73 to approximately 0.74 times the spaced distance of one pair of adjacent circuit lines 31 from among a plurality of circuit lines.

In one or more embodiments, if a distance L1 between the one pair of adjacent circuit lines 31 is approximately 1.5 mm, a distance L2 between the outer surface of the first expansion pad 321 and the outer surface of the second expansion pad 323 may be approximately 1.1 mm.

In one or more embodiments, a distance L3 between a step of the first step side 321a and a step of the second step side 323a may be approximately 0.9 mm. In this embodiment, the area of the solder 60 applied between the first expansion pad 321 and the second expansion pad 323 may be approximately 0.31 mm².

In one or more embodiments, if the distance between one pair of the adjacent circuit lines 31 is approximately 1.1 mm while the step of the first step side 321a and the second step side 323a are not formed, the applied area of the solder 60 at the end of the circuit line is equal to or less than approximately 0.14 mm².

As described above, if the first expansion pad 321 and the second expansion pad 323 are formed at the end of the circuit line 31, the applied area of the solder 60 may be maximized compared to an embodiment in which the first expansion pad 321 and the second expansion pad 323 are not formed.

Further, the surface of the solder 60 connecting the flexible printed circuit 30 and the cell supervision circuit 40 may be conformally coated.

The conformal coating 70 may be applied to cover the entire outer surface of the solder 60 cured for multiple times to connect the flexible printed circuit 30 and the cell supervision circuit 40.

As described above, the rechargeable battery pack 100 according to a first embodiment of the present disclosure electrically connect the flexible printed circuit 30 and the cell supervision circuit 40 not by using an additional terminal (not shown) but by using the electrically conductive solder 60 such as the solder 60, thereby preventing disconnection of lines which might otherwise occur due to compressed damages at the connection portion and thus allowing a stable connection.

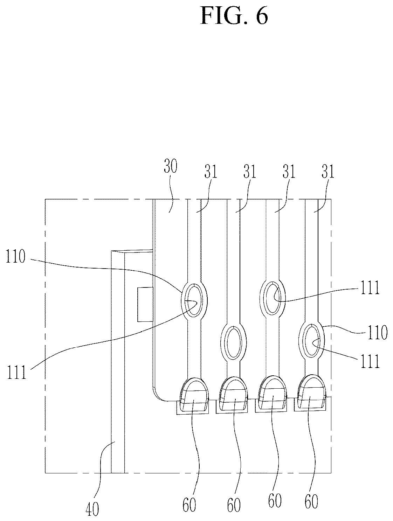

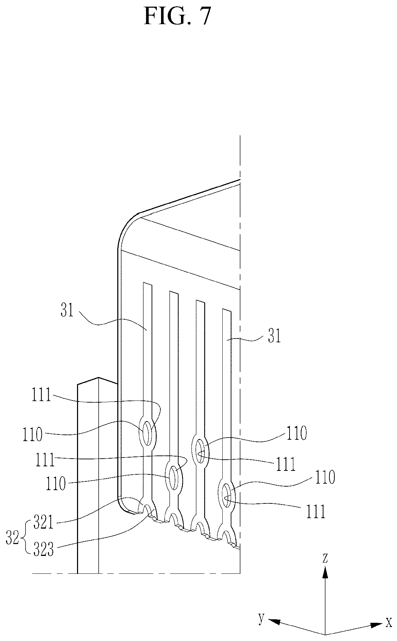

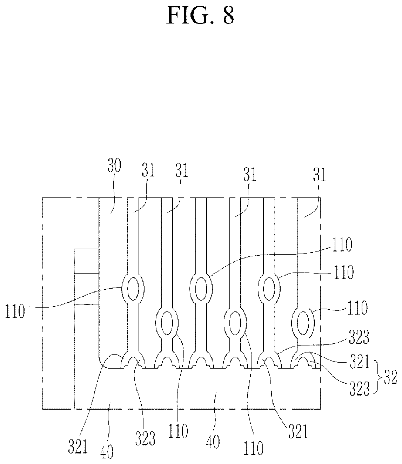

FIG. 6 shows a schematic perspective view of a flexible circuit substrate electrically connected to a cell supervision circuit according to a second embodiment of the present disclosure by an electrically conductive solder, FIG. 7 shows a schematic perspective view of a state in which an electrically conductive solder of FIG. 6 is omitted, and FIG. 8 shows a schematic lateral view of a state in which an electrically conductive solder of FIG. 6 is omitted. The same reference numerals as those in FIG. 1 to FIG. 5 represent identical or similar members with the same or similar functions. No detailed descriptions on the same reference numerals will be provided.

As shown in FIG. 6 to FIG. 8, a sub-pad portion 110 may be formed to be spaced from the conductive pad portion 32 in the respective circuit lines 31 formed on the flexible printed circuit 30 of the rechargeable battery pack according to a second embodiment of the present disclosure (e.g., each circuit line 31 may include a sub-pad portion 110 spaced apart from the conductive pad portion 32).

The sub-pad portion 110 protrudes from the circuit line 31 from a position spaced from the conductive pad portion 32 by a predetermined distance, and a slot hole 111 may be formed sub-pad portion 110.

The sub-pad portion 110 protrudes from the circuit line 31 at a position spaced from the conductive pad portion 32, and the sub-pad portion 110 may protrude in a width direction of the circuit line 31.

A slot hole 111 in a substantial slit shape (e.g., an elongated opening, such as an oval or elliptical shape) that is long in a length direction of the circuit line 31 may be formed at a center position of the sub-pad portion 110. The slot hole 111 is shown to have a slit shape in the sub-pad portion 110, and without being limited thereto, it may have a polygonal or round shape.

Therefore, the solder 60 may be inserted into the slot hole 111 of the sub-pad portion 110 to electrically connect the flexible printed circuit 30 and the cell supervision circuit 40 and thereby increase the strength of the electrical connection.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

### Description of Symbols

10... cell assembly 11...battery cell
20... side frame 21...first side frame
22... second side frame 23...first end frame
24... second end frame 30...flexible printed circuit
31... circuit line 32... conductive pad portion
321..first expansion pad 321a..first step side
322..round groove 323..second expansion pad
323a..second step side 40...cell supervision circuit
60...electrically conductive solder 70... conformal coating
110...sub-pad portion 111... slot hole

## Claims

1. A rechargeable battery pack comprising:
a cell assembly including at least one battery cell;
a side frame accommodating the cell assembly;
a flexible printed circuit electrically connected to the cell assembly and configured to sense at least one property of the battery cell; and
a cell supervision circuit electrically connected to the flexible printed circuit and on one side of the side frame,
wherein the flexible printed circuit is electrically connected to the cell supervision circuit by an electrically conductive solder without using an additional terminal.

2. The rechargeable battery pack as claimed in claim 1, wherein
the electrically conductive solder includes a solder or a conductive glue for electrically connecting the flexible circuit substrate and the cell supervision circuit.

3. The rechargeable battery pack as claimed in claim 1 or claim 2, wherein the flexible printed circuit comprises a plurality of circuit lines and a plurality of conductive pad portions at respective ends of the plurality of circuit lines electrically connected to the cell supervision circuit.

4. The rechargeable battery pack as claimed in claim 3, wherein
at least one conductive pad portion of the plurality of conductive pad portions protrudes from the end of a circuit line of the plurality of circuit lines with a size that is greater than a width of the circuit line and is electrically connected to the cell supervision circuit by the electrically conductive solder.

5. The rechargeable battery pack as claimed in claim 4, wherein
the at least one conductive pad portion includes:
a first expansion pad protruding from a first side of the circuit line in a width direction, and
a second expansion pad protruding from a second side of the circuit line in the width direction.

6. The rechargeable battery pack as claimed in claim 5, wherein
the first expansion pad and the second expansion pad protrude in a round shape from the end of the circuit line in directions that are opposite to each other.

7. The rechargeable battery pack as claimed in claim 6, further comprising a round groove between the first expansion pad and the second expansion pad.

8. The rechargeable battery pack as claimed in claim 7, further comprising
a first step side connected to a lateral side of the flexible printed circuit at an end of the first expansion pad.

9. The rechargeable battery pack as claimed in claim 8, further comprising
a second step side connected to a lateral side of the flexible printed circuit at an end of the second expansion pad.

10. The rechargeable battery pack as claimed in claim 9, further comprising a plated layer on surfaces of the first step side and the second step side.

11. The rechargeable battery pack as claimed in claim 9 or claim 10, wherein
a first spaced distance between an outer surface of the first expansion pad and an outer surface of the second expansion pad is approximately 0.73 to approximately 0.74 times a spaced distance between adjacent circuit lines of the plurality of circuit lines.

12. The rechargeable battery pack as claimed in any one of claims 9 to 11, wherein
the first spaced distance is approximately 1.22 to approximately 1.23 times a second spaced distance between a step of the first expansion pad and a step of the second expansion pad.

13. The rechargeable battery pack as claimed in any one of claims 9 to 12, wherein:
the electrically conductive solder is a cream solder applied to the first step side, the second step side, and the round groove, bonded by laser heat, and electrically connected to the cell supervision circuit; or
the electrically conductive solder is a wire solder applied to the first step side, the second step side, and the round groove, bonded by laser heat, and electrically connected to the cell supervision circuit.

14. The rechargeable battery pack as claimed in any one of claims 3 to 13, wherein at least one circuit line of the plurality of circuit lines includes a sub-pad portion spaced from a conductive pad portion of the plurality of conductive pad portions, the sub-pad portion being electrically connected to the cell supervision circuit by the electrically conductive solder, optionally further comprising a slot hole in the sub-pad portion into which the electrically conductive solder is inserted.

15. The rechargeable battery pack as claimed in any one of claims 1 to 14, wherein
a surface of the electrically conductive solder is conformally coated.

## Patentansprüche

1. Wiederaufladbares Batteriepack, umfassend:
eine Zellenanordnung, einschließend mindestens eine Batteriezelle;
einen Seitenrahmen, der die Zellenanordnung aufnimmt;
eine flexible Leiterplatte, die elektrisch mit der Zellenanordnung verbunden ist und konfiguriert ist, um mindestens eine Eigenschaft der Batteriezelle zu erfassen; und
eine Zellüberwachungsschaltung, die elektrisch mit der flexiblen Leiterplatte und auf einer Seite des Seitenrahmens verbunden ist,
wobei die flexible Leiterplatte elektrisch mit der Zellüberwachungsschaltung durch ein elektrisch leitendes Lötmittel verbunden ist, ohne einen zusätzlichen Anschluss zu verwenden.

2. Wiederaufladbares Batteriepack nach Anspruch 1, wobei
das elektrisch leitende Lötmittel ein Lötmittel oder einen leitenden Klebstoff einschließt, um das flexible Leiterplattensubstrat und die Zellüberwachungsschaltung elektrisch zu verbinden.

3. Wiederaufladbares Batteriepack nach Anspruch 1 oder 2, wobei die flexible Leiterplatte eine Vielzahl von Leiterbahnen und eine Vielzahl von leitenden Pad-Abschnitten an den jeweiligen Enden der Vielzahl von Leiterbahnen umfasst, die elektrisch mit der Zellüberwachungsschaltung verbunden sind.

4. Wiederaufladbares Batteriepack nach Anspruch 3, wobei
mindestens ein leitender Pad-Abschnitt der Vielzahl von leitenden Pad-Abschnitten aus dem Ende einer Leiterbahn der Vielzahl von Leiterbahnen mit einer Größe herausragt, die größer ist als eine Breite der Leiterbahn, und elektrisch mit der Zellüberwachungsschaltung durch das elektrisch leitende Lötmittel verbunden ist.

5. Wiederaufladbares Batteriepack nach Anspruch 4, wobei
der mindestens eine leitende Pad-Abschnitt einschließt:
ein erstes Expansionspad, das von einer ersten Seite der Leiterbahn in einer Breitenrichtung vorsteht, und
ein zweites Expansionspad, das von einer zweiten Seite der Leiterbahn in der Breitenrichtung vorsteht.

6. Wiederaufladbares Batteriepack nach Anspruch 5, wobei
das erste Expansionspad und das zweite Expansionspad mit einer runden Form aus dem Ende der Leiterbahn in entgegengesetzten Richtungen vorstehen.

7. Wiederaufladbares Batteriepack nach Anspruch 6, ferner umfassend eine runde Rille zwischen dem ersten Expansionspad und dem zweiten Expansionspad.

8. Wiederaufladbares Batteriepack nach Anspruch 7, ferner umfassend
eine erste Stufenseite, die mit einer lateralen Seite der flexiblen Leiterplatte an einem Ende des ersten Expansionspads verbunden ist.

9. Wiederaufladbares Batteriepack nach Anspruch 8, ferner umfassend
eine zweite Stufenseite, die mit einer lateralen Seite der flexiblen Leiterplatte an einem Ende des zweiten Expansionspads verbunden ist.

10. Wiederaufladbares Batteriepack nach Anspruch 9, ferner umfassend eine plattierte Schicht auf den Oberflächen der ersten Stufenseite und der zweiten Stufenseite.

11. Wiederaufladbares Batteriepack nach Anspruch 9 oder 10, wobei
ein erster Abstand zwischen einer Außenfläche des ersten Expansionspads und einer Außenfläche des zweiten Expansionspads ungefähr das 0,73- bis ungefähr 0,74-fache eines Abstands zwischen benachbarten Leiterbahnen der Vielzahl von Leiterbahnen ist.

12. Wiederaufladbares Batteriepack nach einem der Ansprüche 9 bis 11, wobei
der erste Abstand ungefähr das 1,22- bis ungefähr 1,23-fache eines zweiten Abstands zwischen einer Stufe des ersten Expansionspads und einer Stufe des zweiten Expansionspads ist.

13. Wiederaufladbares Batteriepack nach einem der Ansprüche 9 bis 12, wobei:
das elektrisch leitende Lötmittel ein Creme-Lötmittel ist, das auf die erste Stufenseite, die zweite Stufenseite und die runde Rille aufgebracht ist, durch Laserwärme gebondet ist und elektrisch mit der Zellüberwachungsschaltung verbunden ist; oder
das elektrisch leitende Lötmittel ein Drahtlot ist, das auf die erste Stufenseite, die zweite Stufenseite und die runde Rille aufgebracht ist, durch Laserwärme gebondet ist und elektrisch mit der Zellüberwachungsschaltung verbunden ist.

14. Wiederaufladbares Batteriepack nach einem der Ansprüche 3 bis 13, wobei mindestens eine Leiterbahn der Vielzahl von Leiterbahnen einen Sub-Pad-Abschnitt einschließt, der von einem leitenden Pad-Abschnitt der Vielzahl von leitenden Pad-Abschnitten beabstandet ist, wobei der Sub-Pad-Abschnitt durch das elektrisch leitende Lötmittel elektrisch mit der Zellüberwachungsschaltung verbunden ist, wahlweise ferner umfassend ein Schlitzloch in dem Sub-Pad-Abschnitt aufweist, in das das elektrisch leitende Lötmittel eingeführt wird.

15. Wiederaufladbares Batteriepack nach einem der Ansprüche 1 bis 14, wobei
eine Oberfläche des elektrisch leitfähigen Lötmittels konform beschichtet ist.

## Revendications

1. Batterie rechargeable comprenant :
un assemblage de cellules incluant au moins une cellule de batterie ;
un châssis latéral accueillant l'assemblage de cellules ;
un circuit imprimé flexible connecté électriquement à l'assemblage de cellules et configuré pour détecter au moins une propriété de la cellule de la batterie ; et
un circuit de supervision de cellule connecté électriquement au circuit imprimé flexible et sur un côté du châssis latéral,
dans lequel le circuit imprimé flexible est connecté électriquement au circuit de supervision de cellule par une soudure électriquement conductrice sans utiliser de borne supplémentaire.

2. Batterie rechargeable selon la revendication 1, dans laquelle
la soudure électriquement conductrice inclut une soudure ou une colle conductrice pour connecter électriquement le substrat du circuit flexible et le circuit de supervision de cellule.

3. Batterie rechargeable selon la revendication 1 ou la revendication 2, dans lequel le circuit imprimé flexible comprend une pluralité de lignes de circuit et une pluralité de parties de plot conducteur aux extrémités respectives de la pluralité de lignes de circuit électriquement connectées au circuit de supervision de cellule.

4. Batterie rechargeable selon la revendication 3, dans laquelle
au moins une partie de plot conducteur de la pluralité de parties de plot conducteur dépasse de l'extrémité d'une ligne de circuit de la pluralité de lignes de circuit avec une taille qui est supérieure à une largeur de la ligne de circuit et est connectée électriquement au circuit de supervision de cellule par la soudure électriquement conductrice.

5. Batterie rechargeable selon la revendication 4, dans laquelle
l'au moins une partie de plot conducteur inclut :
un premier plot d'expansion faisant saillie d'un premier côté de la ligne de circuit dans le sens de la largeur, et
un deuxième plot d'expansion faisant saillie d'un deuxième côté de la ligne de circuit dans le sens de la largeur.

6. Batterie rechargeable selon la revendication 5, dans laquelle
le premier plot d'expansion et le deuxième plot d'expansion font saillie en forme ronde à partir de l'extrémité de la ligne de circuit dans des directions opposées l'une à l'autre.

7. Batterie rechargeable selon la revendication 6, comprenant en outre une rainure ronde entre le premier plot d'expansion et le deuxième plot d'expansion.

8. Batterie rechargeable selon la revendication 7, comprenant en outre
un premier côté de marche connecté à un côté latéral du circuit imprimé flexible au niveau d'une extrémité du premier plot d'expansion.

9. Batterie rechargeable selon la revendication 8, comprenant en outre
un deuxième côté de marche connecté à un côté latéral du circuit imprimé flexible au niveau d'une extrémité du deuxième plot d'expansion.

10. Batterie rechargeable selon la revendication 9, comprenant en outre une couche plaquée sur les surfaces du premier côté de marche et du deuxième côté de marche.

11. Batterie rechargeable selon la revendication 9 ou la revendication 10, dans laquelle
un premier écart entre une surface extérieure du premier plot d'expansion et une surface extérieure du deuxième plot d'expansion est approximativement de 0,73 à approximativement 0,74 fois un écart entre des lignes de circuit adjacentes de la pluralité de lignes de circuit.

12. Batterie rechargeable selon l'une quelconque des revendications 9 à 11, dans laquelle
le premier écart est d'environ 1,22 à environ 1,23 fois un deuxième écart entre une marche du premier plot d'expansion et une marche du deuxième plot d'expansion.

13. Batterie rechargeable selon l'une quelconque des revendications 9 à 12, dans laquelle :
la soudure électriquement conductrice est une soudure en crème appliquée sur le premier côté de marche, le deuxième côté de marche et la rainure ronde, liée par chaleur par laser et connectée électriquement au circuit de supervision de cellule ; ou
la soudure électriquement conductrice est une soudure au fil appliquée sur le premier côté de marche, le deuxième côté de marche et la rainure ronde, liée par chaleur par laser et connectée électriquement au circuit de supervision de cellule.

14. Batterie rechargeable selon l'une quelconque des revendications 3 à 13, dans laquelle au moins une ligne de circuit de la pluralité de lignes de circuit inclut une partie de sous-plot espacée d'une partie de plot conducteur de la pluralité de parties de plot conducteur, la partie de sous-plot étant connectée électriquement au circuit de supervision de cellule par la soudure électriquement conductrice, facultativement comprenant en outre un trou de fente dans la partie de sous-plot dans lequel la soudure électriquement conductrice est insérée.

15. Batterie rechargeable selon l'une quelconque des revendications 1 à 14, dans laquelle
une surface de la soudure électriquement conductrice est conformément recouverte.
